# EUROPEAN PATENT APPLICATION

(11) **EP 4 472 355 A1**
(43) Date of publication of application: **04.12.2024**
(21) Application number: 23747326.9
(22) Date of filing: 26.01.2023
(51) Int. Cl.: H05B 6/12, H02J 50/70, H01F 27/36, F24C 7/08, H05K 9/00, H05B 6/06

(54) **MEHOD AND DEVICE FOR ELIMINATIING NOISE OF COOKING DEVICE BY USING WIRELESS POWER TRANSMISSION**

(30) Priority: 27.01.2022 KR 20220012591; 25.07.2022 KR 20220092042
(71) Applicant: Samsung Electronics Co., Ltd., Gyeonggi-do, 16677 (KR)
(72) Inventor: KIM, Hwasung, Suwon-si, Gyeonggi-do 16677 (KR); BYUN, Hyosu, Suwon-si, Gyeonggi-do 16677 (KR)
(74) Representative: Gulde & Partner
(86) International application number: PCT/KR2023/001162
(87) International publication number: WO 2023/146285

(57) **Abstract**

A heating device according to an embodiment of the present disclosure includes a wireless power transmitter including at least one transmitting coil enabling cooking by wirelessly transmitting power to a cooking container or a cooking utensil, a touch panel unit configured to receive a user input, a control printed circuit board (PCB) including a processor configured to control the wireless power transmitter according to a user input received from the touch panel unit, and a grounded shielding conductor arranged perpendicular to the control PCB between the touch panel unit and the control PCB.

## Description

### Technical Field

Embodiments of the present disclosure relate to a method and apparatus by which a cooking device using wireless power transfer shields against noise.

### Background Art

Wireless power transfer (WPT) technology indicates a technology in which a power cord for supplying power to a home appliance or an electric vehicle is removed and replaced wirelessly.

With the development of technology for freely supplying required power wirelessly wherever a device that requires power is located, power supply and power cable-related paradigms are innovatively changing not only for home appliance applications, but also for information technology (IT).

WPT technologies have been developed in various frequency domains, but it is difficult to commercialize most WPT technologies, excluding a non-contact type induction coupling method using low frequencies of hundreds of kHz. The non-contact type induction coupling method uses a relatively low frequency and thus can be applied to an inexpensive switching type power conversion element and has excellent power transmission efficiency. In this regard, the non-contact type induction coupling method has been commercialized for cordless razors, electric toothbrushes, and the like, and has recently been applied to mobile IT devices such as mobile phones.

WPT according to the non-contact type induction coupling method is a method of wirelessly transmitting/receiving power by mutually linking a transmitting-side transmitting coil (magnetic resonator) including a power source to a receiving-side receiving coil wirelessly receiving power.

Recently, an induction cooking device has been widely used by heating a container without a receiving coil, which uses an eddy current induced by a transmitting coil. Here, a touch panel provided on a top plate of the cooking device may be affected by noise generated by WPT and an eddy current induced in a cooking utensil.

### Disclosure

### Technical Solution

A cooking device according to an embodiment of the present disclosure includes a wireless power transmitter including at least one transmitting coil and configured to wirelessly transmit power through the transmitting coil. The cooking device includes a touch panel unit configured to receive a user input. The cooking device includes a printed circuit board (PCB) including a processor configured to control the wireless power transmitter according to a user input received from the touch panel unit. The cooking device includes a grounded shielding conductor arranged perpendicular to the PCB between the touch panel unit and the PCB.

### Description of Drawings

FIG. 1 is a diagram for describing a wireless power driven cooking system according to an embodiment of the present disclosure.
FIG. 2 illustrates a cooking device including a touch panel unit, according to an embodiment of the present disclosure.
FIG. 3A is a cross-sectional view illustrating electromagnetic noise affecting a touch panel unit.
FIG. 3B is a cross-sectional view illustrating a method of shielding against an electromagnetic wave when the electromagnetic wave affects a touch panel unit, according to an embodiment of the present disclosure.
FIGS. 4A, 4B, and 4C are diagrams illustrating changes in a capacitance value according to a touch operation on a touch panel unit, according to an embodiment of the present disclosure.
FIG. 5A illustrates a heating device including a grounded shielding printed circuit board (PCB), according to an embodiment of the present disclosure.
FIG. 5B illustrates a heating device including a grounded shielding metal bar, according to an embodiment of the present disclosure.
FIG. 5C illustrates a shielding conductor being mounted on a control PCB, according to an embodiment of the present disclosure.
FIG. 5D is an aerial view illustrating a shielding conductor surrounding a control PCB, according to an embodiment of the present disclosure.
FIG. 6A is a touch data waveform diagram illustrating a normal touch operation in an induction heating device, according to an embodiment of the present disclosure.
FIG. 6B is a waveform diagram illustrating electromagnetic noise during a touch operation in a heating device when a shielding conductor is not provided.
FIG. 6C is a waveform diagram illustrating touch noise during a touch operation in a heating device when a shielding conductor is provided, according to an embodiment of the present disclosure.
FIG. 7 is a block diagram of a heating device including an electromagnetic noise shielding conductor, according to an embodiment of the present disclosure.
FIG. 8 is a method by which a heating device shields against electromagnetic noise, according to an embodiment of the present disclosure.

### Mode for Invention

The terms used in the present disclosure will be briefly defined, and an embodiment of the present disclosure will be described in detail.

All terms including descriptive or technical terms which are used herein should be construed as having meanings that are obvious to one of ordinary skill in the art. However, the terms may have different meanings according to the intention of one of ordinary skill in the art, precedent cases, or the appearance of new technologies. Also, some terms may be arbitrarily selected by the applicant, and in this case, the meaning of the selected terms will be described in detail in the detailed description of an embodiment of the present disclosure. Thus, the terms used herein have to be defined based on the meaning of the terms together with the description throughout the specification.

When a part "includes" or "comprises" an element, unless there is a particular description contrary thereto, the part may further include other elements, rather than excluding the other elements. In addition, terms such as "unit (-er/or)" and "module" described in the present disclosure denote a unit that processes at least one function or operation, which may be implemented in hardware or software, or implemented in a combination of hardware and software.

Throughout the specification, a cooking device may be used as a same meaning as a heating device.

Hereinafter, an embodiment of the present disclosure will be described in detail with reference to the accompanying drawings such that one of ordinary skill in the art may easily implement the embodiment of the present disclosure. However, an embodiment of the present disclosure may be implemented in various different forms and is not limited to an embodiment described herein. Also, in the drawings, parts irrelevant to the description are omitted in order to clearly describe an embodiment of the present disclosure, and like reference numerals designate like elements throughout the specification.

In an induction heating type home appliance, touch recognition is affected by electromagnetic noise, and thus, it is required to prevent electromagnetic noise and stably recognize a touch in a home appliance employing induction heating.

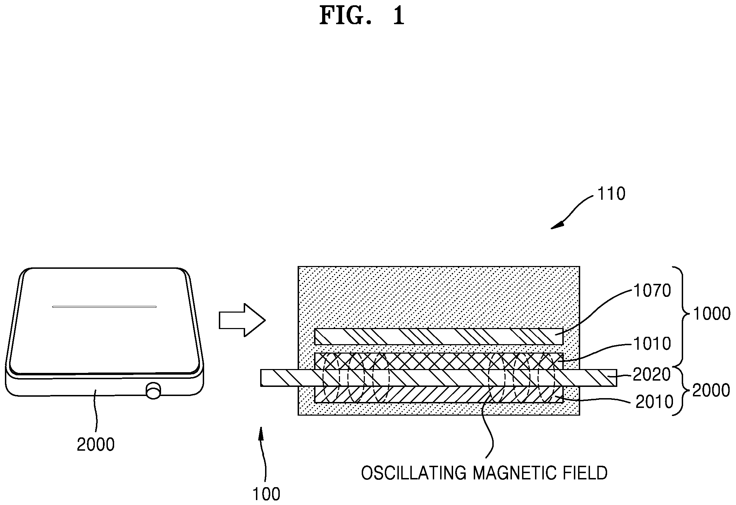

FIG. 1 is a diagram for describing a wireless power driven cooking system according to an embodiment of the present disclosure.

As shown in FIG. 1, a cooking container 1000 of a cooking system 100 driven with wireless power indicates any type of home cooking container or container for cooking using an induction heating method or a heating method. The cooking container 1000 according to the present disclosure includes a cooking utensil for "heating", but it should be understood that the cooking container 1000 includes not only a cooking container for "heating", but also a cooking utensil operated as "power" is supplied wirelessly.

Being driven with wireless power may indicate that the cooking container 1000 is heated or an electricity output is obtained by transmitting power by using a magnetic field induced in a receiving coil or metal (e.g., an iron) of the cooking container 1000 through a magnetic induction method. For example, a heating device 2000 of FIG. 1 may transmit a current to a wireless power transmitter 2010 including an operating coil (or a transmitting coil) to form a magnetic field, such that an eddy current is generated in the cooking container 1000 or a magnetic field is induced in a wireless power receiver 1010 including the receiving coil. The electricity output or heating is performed through the eddy current induced as such or through the magnetic field induced in the wireless power receiver 1010.

An induction cooking container using electromagnetic induction is illustrated as an example of the cooking container 1000 of FIG. 1. However, the cooking container 1000 driven with wireless power, according to the present disclosure, is not limited to the induction cooking container. Examples of the cooking container 1000 according to the present disclosure may include a coffee machine, a toaster, an induction heater, an electric rice cooker, an electric waffle maker, a blender, an electric kettle, a pot, a frying pan, and a steamer, but are not limited thereto. The cooking container 1000 may be a container with magnetic properties, which may be inductively heated by the heating device 2000 and communicate with the heating device 2000. Contents of the cooking container 1000 driven with wireless power may be liquids, such as water, tea, coffee, soup, and the like, or may be solids, such as butter, meat, vegetables, and the like, but are not limited thereto.

According to an embodiment of the present disclosure, the cooking container 1000 may be an induction heating (IH) type cooking utensil or a heater type cooking utensil. IH is a method of heating a metal object by using an electromagnetic induction phenomenon. For example, when an alternating current is supplied to the wireless power transmitter 2010 of the heating device 2000, a magnetic field - an oscillating magnetic field - that changes over time is inducted inside the transmitting coil included in the wireless power transmitter 2010. The magnetic field generated by the transmitting coil passes through a bottom surface of the cooking container 1000. When the magnetic field that changes over time passes through a metal (e.g., iron, steel, nickel, or alloy) included in the bottom surface of the cooking container 1000, a current that rotates based on the magnetic field is generated in the metal. Such rotating current is referred to as an eddy current and a phenomenon in which a current is induced by the magnetic field that changes over time is referred to as an electromagnetic induction phenomenon. When the cooking container 1000 is an IH type cooking utensil, heat is generated at the bottom surface of the cooking container 1000 according to frictional heat caused by resistance of the metal (e.g., iron) when the eddy current flows. The contents of the cooking container 1000 may be heated by the heat generated at this time. Also, when the magnetic field according to the IH method is formed, the magnetic field may affect an operation of a surrounding electronic device through electromagnetic noise.

When the cooking container 1000 is a heater type cooking utensil, the cooking container 1000 may include the wireless power receiver 1010 including the receiving coil driving a load. The load may be, in addition to a heater or a motor, any electric load that is capable of operating a home appliance. The cooking container 1000 may include, as an example of an internal load, a heater, a motor, or a charging target battery. The wireless power receiver 1010 may supply power to any unit that is operable by receiving power, in addition to heating a heater or driving a motor as the load.

The heater heats the contents in the cooking container 1000. A shape of the heater may vary, and a material (e.g., iron, stainless steel, copper, aluminum, Incoloy, Inconel, or the like) of an outer case thereof may also vary.

The receiving coil of the cooking container 1000 may receive power wirelessly through a magnetic induction method from the transmitting coil included in the wireless power transmitter 2010 of the heating device 2000. The magnetic induction method is a method of transferring energy by applying, to the receiving coil, a magnetic field generated by a current flowing through the transmitting coil.

A reference numeral 110 of FIG. 1 illustrates a cross-sectional view of the heating device 2000 and the cooking container 1000 driven with wireless power. Referring to the reference numeral 110 of FIG. 1, the heating device 2000 includes the wireless power transmitter 2010 that includes the transmitting coil for receiving commercial power via wires and transmitting the commercial power wirelessly.

The cooking container 1000 includes the wireless power receiver 1010 that includes the receiving coil for receiving power wirelessly from the transmitting coil of the heating device 2000 through the magnetic induction method. A load 1070 heated by the receiving coil is provided at the top of the wireless power receiver 1010 of the cooking container 1000. The load 1070 may include a heater, a motor, or a charging target battery.

The heating device 2000 may include glass 2020 on the wireless power transmitter 2010. The glass 2020 of the heating device 2000 may be configured as tempered glass such as ceramic glass such that a top plate of the heating device 2000 is not easily damaged.

There is no wired connection between the heating device 2000 and the cooking container 1000 including the wireless power receiver 1010 and the load 1070, and thus, the cooking container 1000 may be freely separated from the heating device 2000 including the wireless power transmitter 2010, in a cord-free state.

A cooking device according to an embodiment of the present disclosure may be an integral type including the cooking container 1000 and the heating device 2000. For example, the cooking container 1000 and the heating device 2000 may be separately handled and sold products, or the cooking container 1000 and the heating device 2000 may be a cooking device that is a home appliance treated as one product. Throughout the specification, the heating device 2000 may also be referred to as a station (device) or a cooking device.

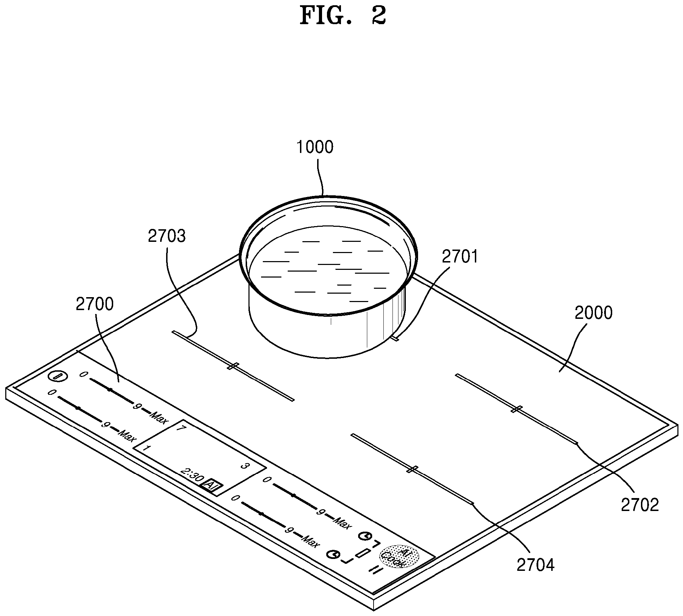

FIG. 2 illustrates a cooking device including a touch panel unit, according to an embodiment of the present disclosure.

Referring to FIG. 2, a touch panel unit 2700 for receiving a touch input of a user may be provided on the top plate of the heating device 2000. When a user input is applied to the touch panel unit 2700, a function of the heating device 2000, corresponding to a touched region, is performed and the cooking container 1000 may be heated.

Four cooking regions, i.e., a first cooking region 2701, a second cooking region 2702, a third cooking region 2703, and a fourth cooking region 2704, may be provided on the heating device 2000. However, this is only an embodiment and a more or fewer cooking regions may be provided according to a specification of the heating device 2000.

When the heating device 2000 heats the cooking container 1000 through an induction heating method or a receiving coil method, electromagnetic noise is generated, and such electromagnetic noise may affect touch recognition of the touch panel unit 2700.

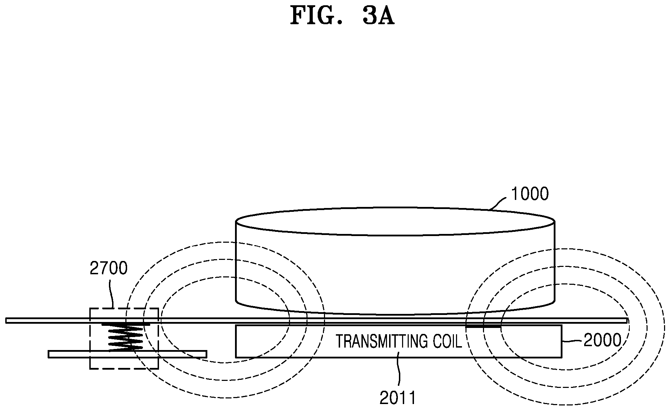

FIG. 3A is a cross-sectional view illustrating electromagnetic noise affecting a touch panel unit.

Referring to FIG. 3A, an electromagnetic wave generated when a transmitting coil 2011 of the heating device 2000 transmits wireless power to the cooking container 1000 affects the touch panel unit 2700. Such an effect of the electromagnetic wave may cause touch misrecognition in the touch panel unit 2700. Thus, an appropriate action is required such that a touch on the touch panel unit 2700 is not misrecognized due to the electromagnetic wave.

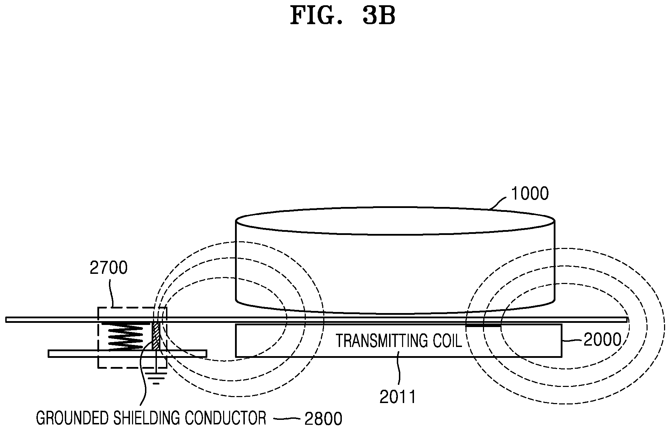

FIG. 3B is a cross-sectional view illustrating a method of shielding against an electromagnetic wave when the electromagnetic wave affects a touch panel unit, according to an embodiment of the present disclosure.

Referring to FIG. 3B, the electromagnetic wave generated according to wireless power transfer between the cooking container 1000 and the heating device 2000 is shielded by a shielding conductor 2800 arranged perpendicular to the touch panel unit 2700 and in parallel to a touch spring portion below the touch panel unit 2700. By locating the shielding conductor 2800 between the touch panel unit 2700 and the wireless power transmitter 2010 of the heating device 2000, which performs the wireless power transfer, an effect of the electromagnetic wave on the touch panel unit 2700 may be minimized.

Generally, the touch panel unit 2700 is integrated with a printed circuit board (PCB) (not shown) including a processor configured to control the heating device 2000 or is at least electrically connected to the PCB in most cases, and thus the shielding conductor 2800 may be integrated with a PCB - a control PCB - including a control processor or electrically connected to at least one PCB. In the present specification, the PCB is referred to as a control PCB configured to control the heating device 2000, but is not limited thereto, and may be a PCB including a control and analog circuits. Also, in the present specification, the control PCB may be simply referred to as a PCB.

According to an embodiment, the shielding conductor 2800 is a conductor for shielding and may be a shielding PCB on which a conductive pattern is etched. The conductive pattern may be etched in various manners. For example, the conductive pattern may be etched on the shielding PCB in a hatched pattern, but is not limited thereto. As another example, the conductive pattern may be formed such that a conductor forms one layer in the shielding PCB.

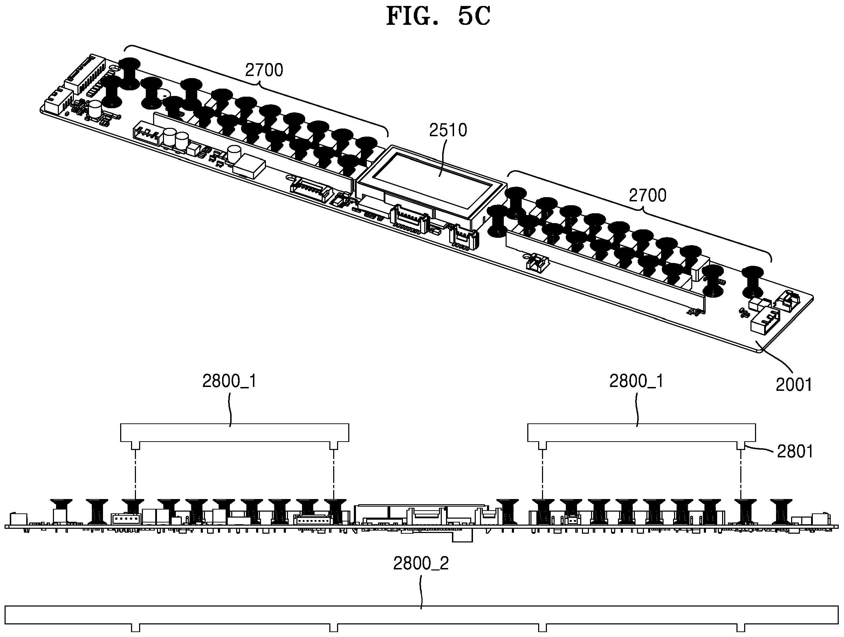

According to an embodiment, the shielding conductor 2800 is a conductor for shielding and may be a conductive metal bar. In other words, the shielding conductor 2800 may be mounted on the control PCB, in the form of a bar entirely including a metal material. The conductive metal bar may be soldered perpendicular to the control PCB. An embodiment in which the shielding conductor 2800 is mounted on the control PCB will be described in detail below with reference to FIG. 5C.

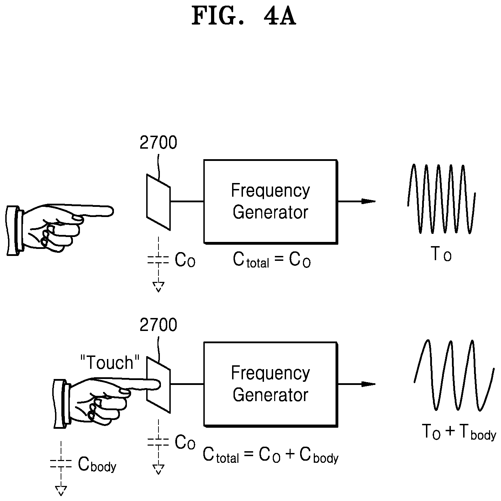

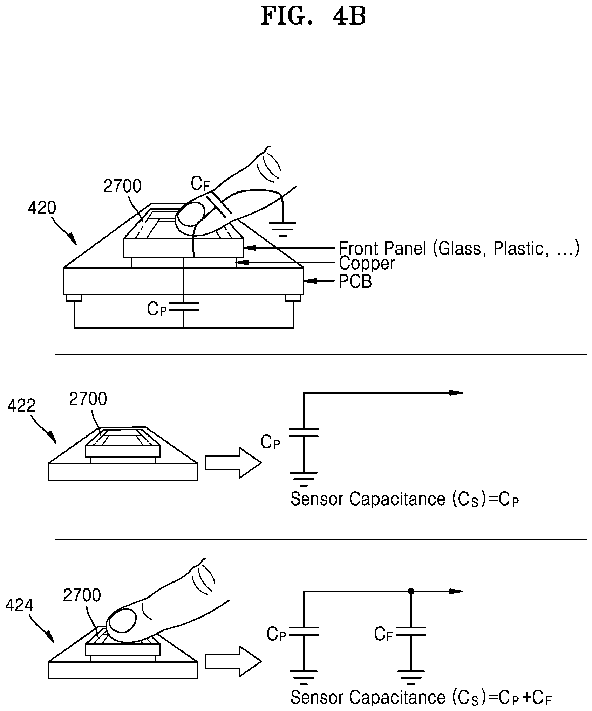

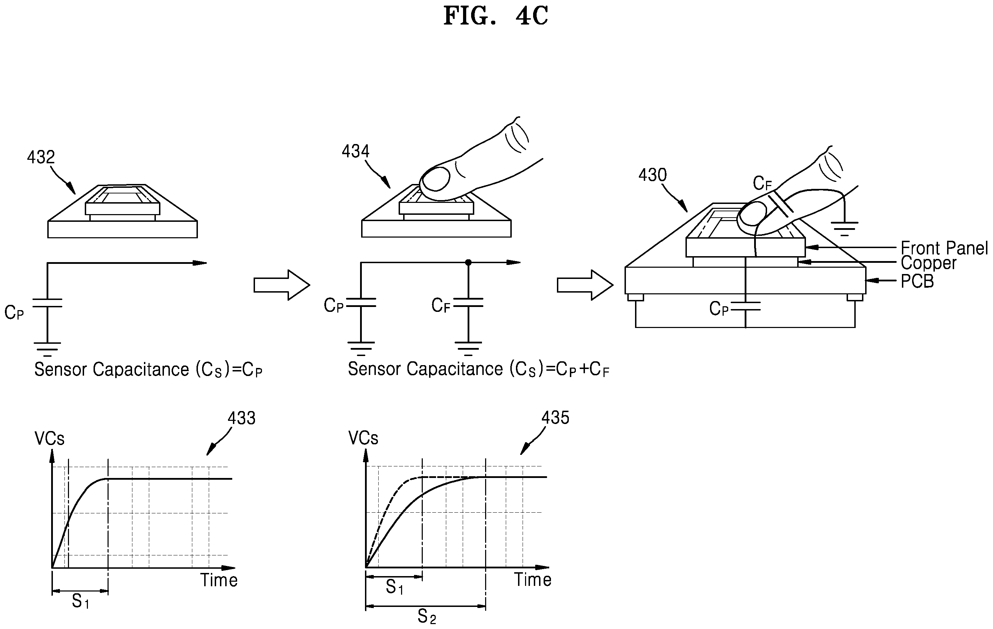

FIGS. 4A, 4B, and 4C are diagrams illustrating changes in a capacitance value according to a touch operation on a touch panel unit, according to an embodiment of the present disclosure.

FIG. 4A illustrates a change in a capacitance value when the touch panel unit 2700 is touched. Referring to FIG. 4A, a capacitance value between the touch panel unit 2700 and the ground before a user touches the touch panel unit 2700 is Cₒ. Thus, total capacitor value Cₜₒₜₐₗ = Cₒ and when the capacitance value Cₒ before the touch is converted into a frequency through an oscillator circuit, a final frequency value is 1/Tₒ.

When the user touches the touch panel unit 2700, a capacitance value C_{body} between the user's body and the ground affects the total capacitance value, and thus, Cₜₒₜₐₗ = Cₒ + C_{body}. When the changed capacitance value Cₜₒₜₐₗ = Cₒ + C_{body} is converted into a frequency through the oscillator circuit, 1/(Tₒ + T_{body}), and thus, a time delay occurs and the processor of the heating device 2000 recognizes a "touch" based on a value of the time delay.

However, the capacitance C_{body} generated by a touch of a human body is a very small value that is only several pF, and a method of accurately detecting the same is an important technology in "touch recognition".

FIG. 4B is a diagram illustrating a change in a capacitance value according to a touch operation on a touch panel unit, according to an embodiment of the present disclosure.

Referring to FIG. 4B, a reference numeral 422 illustrates a state in which the touch panel unit 2700 is not touched by a person. Here, sensor capacitance Cs between the touch panel unit 2700 and the grounds is Cp. Cp is unique parasitic capacitance present between a sensor and the ground. A reference numeral 424 illustrates a state in which the touch panel unit 2700 is touched by a person. When capacitance between a body part (e.g., a finger) performing a touch and the ground is C_{F}, the sensor capacitance Cs is Cp + C_{F}.

A reference numeral 420 is a diagram further illustrating a circuit where capacitance is formed when the touch panel unit 2700 is touched by a person. As shown in the reference numeral 420, when the touch panel unit 2700 is touched, the capacitance C_{F} formed between the body part and the ground is instantaneously added, in parallel to the existing capacitance Cp formed between the touch panel unit 2700 and the ground, and thus, a capacitance value viewed from the touch panel unit 2700 is instantaneously increased. As such, the processor of the heating device 2000 detects a change in the capacitance value between the touch panel unit 2700 and the ground to determine touch recognition.

FIG. 4C further illustrates graphs showing a change in a capacitance value according to a touch operation on a touch panel unit, according to an embodiment of the present disclosure.

The larger a value of capacitance of a capacitor, the more a change in a voltage at both ends of the capacitor is reduced. A reference numeral 432 of FIG. 4C illustrates a state in which the touch panel unit 2700 is not yet touched by a user. Here, referring to a graph 433, a time taken for a voltage VCs at both ends between the touch panel unit 2700 and the ground to reach a maximum value from 0 and be stabilized is S₁.

However, as indicated by a reference numeral 434 of FIG. 4C, when a touch is performed, capacitance instantaneously sensed by the touch panel unit 2700 is Cs = Cp + C_{F}, and thus the capacitance is slightly increased. Accordingly, as shown in a graph 435, the time taken for the voltage VCs at both ends between the touch panel unit 2700 and the ground to reach the maximum value from 0 and be stabilized is increased from S₁ to S₂. Accordingly, the processor of the heating device 2000 may identify the time taken for the voltage at both ends between the touch panel unit 2700 and the ground to be stabilized and recognize a touch. A reference numeral 430 illustrates an electric circuit that is instantaneously formed when the touch panel unit 2700 is touched.

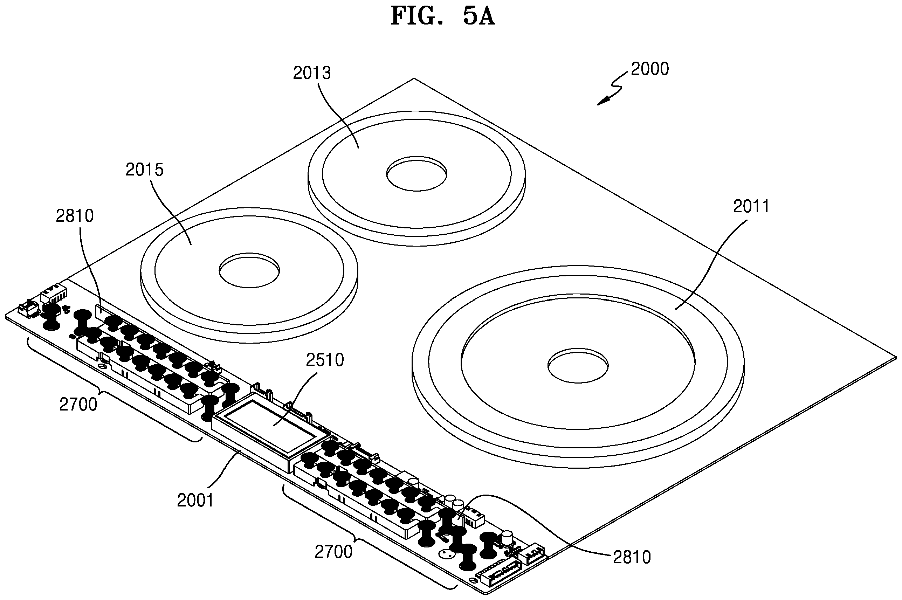

FIG. 5A illustrates a heating device including a grounded shielding PCB, according to an embodiment of the present disclosure.

FIG. 5A illustrates the inside of the heating device 2000 while the top plate glass of the heating device 2000 is removed. The heating device 2000 according to FIG. 5A includes three transmitting coils 2011, 2013, and 2015, and includes a control PCB 2001 at the bottom. The control PCB 2001 may include the touch panel unit 2700, a display unit 2510, and a shielding PCB 2810 as the shielding conductor 2800. In FIG. 5A, because the top plate glass of the heating device 2000 is removed, a top plate touch panel portion that may be touched by a user is removed, and thus, touch springs inside the touch panel unit 2700 are illustrated.

In FIG. 5A, the shielding PCB 2810 is erected perpendicularly between the control PCB 2001 and the transmitting coils 2011, 2013, and 2015 for efficient shielding. The shielding PCB 2810 according to FIG. 5A is a shielding conductor including a PCB. The shielding PCB 2810 is obtained by etching a conductive pattern on the PCB, and a hatched pattern may be used, but the shielding PCB 2810 is not limited thereto. The conductive pattern may be etched on both surfaces of the shielding PCB 2810. In addition, a shielding effect may be better when the area of the conductive pattern is large, and thus, according to an embodiment, the conductive pattern may not be etched on the shielding PCB 2810 but the shielding PCB 2810 may be manufactured such that one entire layer is a shielding conductor. The shielding PCB 2810 may be perpendicularly mounted on the control PCB 2001, and thus may be manufactured as a separate PCB, but may be manufactured as an integrated PCB that is not required to be soldered to the control PCB 2001.

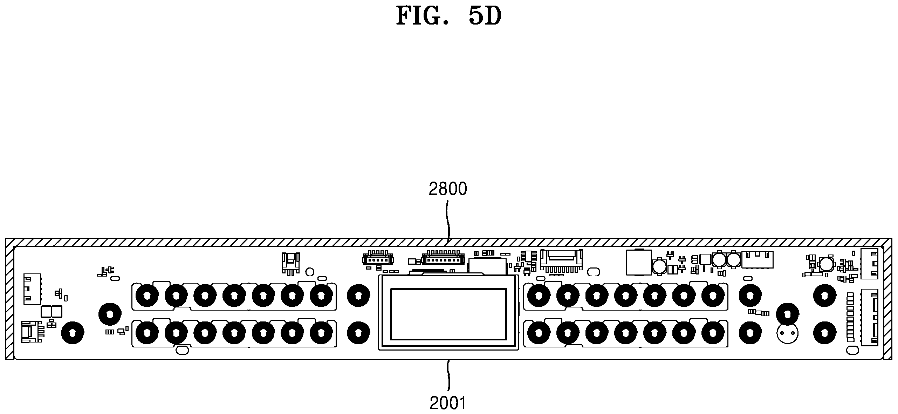

Referring to FIG. 5A, considering a distance and proximity to the control PCB 2001, it is determined that the transmitting coil 2015 among several transmitting coils is a transmitting coil that exerts greatest electromagnetic wave effect on the control PCB 2001. To prevent touch misrecognition of the touch panel unit 2700 due to an electromagnetic wave, the shielding PCB 2810 may be manufactured to have a length that is the same as or greater than a length of the control PCB 2001 or touch panel unit 2700, thereby maximizing a shielding effect. Here, the shielding PCB 2810 having the same length as the control PCB 2001 or touch panel unit 2700 indicates that the lengths thereof are the same or are the same within a minimum tolerance. According to an embodiment, the shielding conductor 2800, as the shielding PCB 2810, may surround the touch panel unit 2700 or the control PCB 2001, in the form in which a concave ( 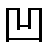 ) shape faces downward, thereby further increasing the shielding effect with respect to the transmitting coils 2011, 2013, and 2015. Such a shape is shown in FIG. 5D.

FIG. 5D will now be referenced. FIG. 5D is an aerial view illustrating a shielding conductor surrounding a control PCB, according to an embodiment of the present disclosure.

As described above, the shielding conductor 2800 surrounds the control PCB 2001, in the concave ( 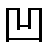 ) shape facing downward. Accordingly, by using the shielding conductor 2800 according to FIG. 5D, an electromagnetic wave generated from a transmitting coil may be shielded in three directions against the control PCB 2001.

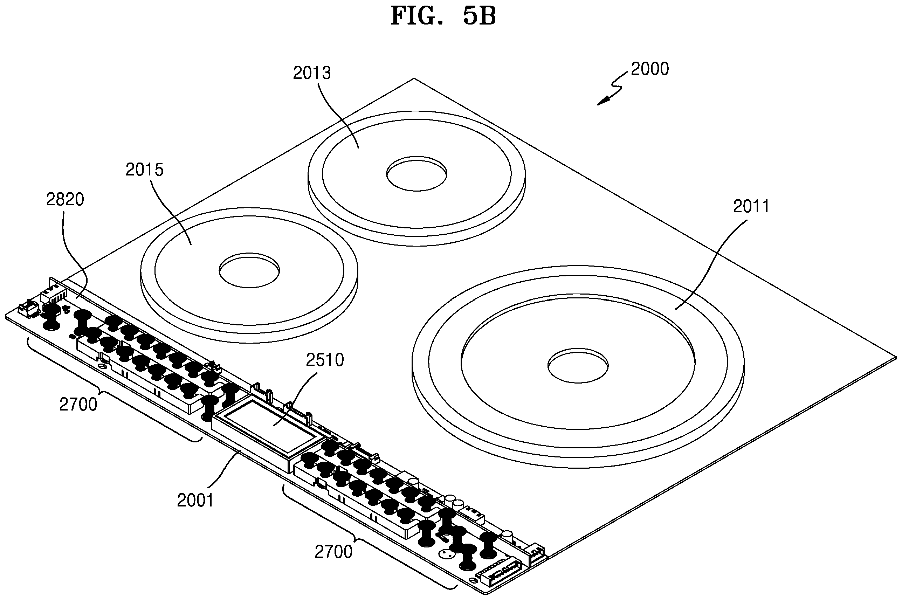

FIG. 5B illustrates a heating device including a grounded shielding metal bar, according to an embodiment of the present disclosure.

The shielding conductor 2800 according to FIG. 5B is a metal bar 2820 including a metal material. According to an embodiment, like the shielding PCB 2810 described above, the metal bar 2820 may also be mounted perpendicular to the control PCB 2001 through soldering. The entire metal bar 2820 is a conductor, and thus a shielding efficiency may be greater than the shielding PCB 2810, but a weight may be greater than the shielding PCB 2810.

FIG. 5B illustrates the inside of the heating device 2000 while the top plate glass of the heating device 2000 is removed. The heating device 2000 according to FIG. 5B includes the transmitting coils 2011, 2013, and 2015, and includes the control PCB 2001 at the bottom. The control PCB 2001 may include the touch panel unit 2700, the display unit 2510, and the metal bar 2820 as the shielding conductor 2800. In FIG. 5B, because the top plate glass of the heating device 2000 is removed, the top plate touch panel portion that may be touched by the user is removed, and thus, touch springs below the touch panel unit 2700 are illustrated.

In FIG. 5B, the metal bar 2820, as the shielding conductor 2800, is erected perpendicularly between the control PCB 2001 and the transmitting coils 2011, 2013, and 2015 for efficient shielding. Referring to FIG. 5B, considering the distance and proximity to the control PCB 2001, it is determined that the transmitting coil 2015 among several transmitting coils is a transmitting coil that exerts greatest electromagnetic wave effect on the control PCB 2001. To prevent touch misrecognition of the touch panel unit 2700 due to an electromagnetic wave, the metal bar 2820 may be manufactured to have a length that is the same as or greater than the length of the control PCB 2001 or touch panel unit 2700, thereby maximizing a shielding effect. Here, the metal bar 2820 having the same length as the control PCB 2001 or touch panel unit 2700 indicates that the lengths thereof are the same or are the same within a minimum tolerance. According to an embodiment, the minimum tolerance may be, for example, 5 mm to 5 cm. According to an embodiment, the shielding conductor 2800 that is the metal bar 2820 may surround the touch panel unit 2700 or the control PCB 2001, in the form in which a concave ( 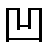 ) shape faces downward, thereby further increasing the shielding effect with respect to the transmitting coils 2011, 2013, and 2015. Such a shape is illustrated in FIG. 5D described above. FIG. 5D illustrates the shielding conductor 2800 surrounding the control PCB 2001, according to an embodiment of the present disclosure. Accordingly, by using the shielding conductor 2800 according to FIG. 5D, electromagnetic waves generated from the transmitting coils 2011, 2013, and 2015 may be shielded in three directions. According to an embodiment, when the cost of manufacturing the shielding conductor 2800 in the concave ( 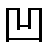 ) shape is high, the shielding effect may be further increased by increasing the length of the shielding conductor 2800 to be greater than that of the control PCB 2001 by more than the minimum tolerance.

FIG. 5C illustrates a shielding conductor being mounted on a control PCB, according to an embodiment of the present disclosure.

According to an embodiment of FIG. 5C, the shielding conductor 2800 is perpendicularly mounted on the control PCB 2001. Here, the shielding conductor 2800 may be divided into two shielding conductors 2800_1, and may be mounted on the control PCB 2001 by being divided into two such that lengths thereof are the same as lengths of the touch panel units 2700 divided on both sides based on the display unit 2510, within a certain range. According to an embodiment, the shielding conductor 2800 may be mounted on the control PCB 2001 by being manufactured as one shielding conductor 2800_2 having a same length as the entire length of the control PCB 2001 or as the entire length of the control PCB 2001 within a certain tolerance value. When the shielding conductor 2800 has the same length as the entire length of the control PCB 2001 or as the entire length of the control PCB 2001 within the certain tolerance value, a shielding effect from electromagnetic noise may be further increased when operations of the control PCB 2001 are performed, as well as the display unit 2510, as shown in FIG. 5C.

The shielding conductors 2800_1 and 2800_2 may include a protrusion insertion portion 2801 therebelow and may be perpendicularly inserted into the control PCB 2001 through the protrusion insertion portion 2801. The protrusion insertion portion 2801 may be mechanically inserted into the control PCB 2001 or may be inserted thereinto through soldering.

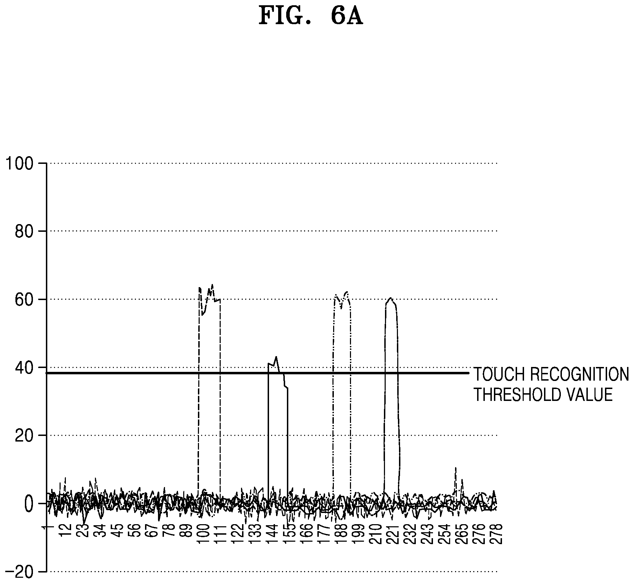

FIG. 6A is a touch data waveform diagram illustrating a normal touch operation in an induction heating device, according to an embodiment of the present disclosure.

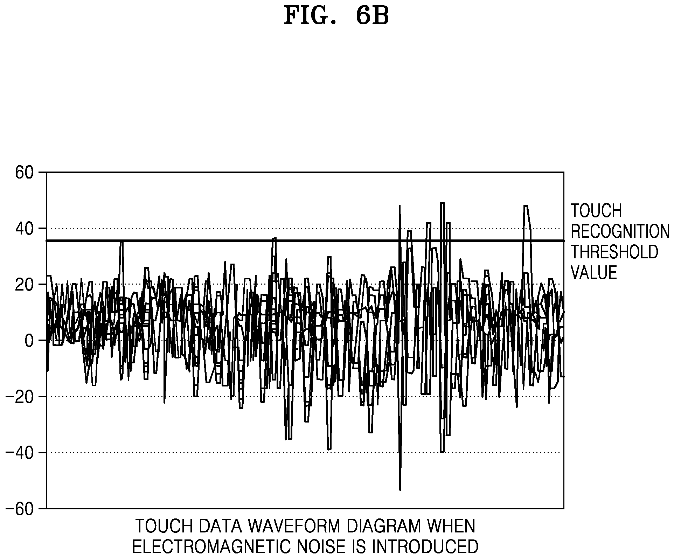

When the user touches the touch panel unit 2700, touch data exceeds a touch recognition threshold value that is a value close to an approximate touch scale value 40, as shown in FIG. 6A. Accordingly, the processor of the heating device 2000 recognizes a touch when data according to the touch exceeds the touch recognition threshold value. However, this assumes a case where an effect of an electromagnetic wave - electromagnetic noise - generated in the heating device 2000 is not large, and FIG. 6B is a waveform diagram considering an effect of an electromagnetic wave in the heating device 2000.

FIG. 6B is a waveform diagram illustrating electromagnetic noise during a touch operation in a heating device when a shielding conductor is not provided.

Referring to FIG. 6B, when electromagnetic noise is introduced and the electromagnetic noise is large despite that an actual touch is not performed, a touch scale value exceeding a touch recognition threshold value is generated, which leads to touch misrecognition. Accordingly, unless appropriate shielding is performed, a touch recognition error may occur due to the electromagnetic noise generated between a transmitting coil and the cooking container 1000 when wireless power transfer is performed in the heating device 2000.

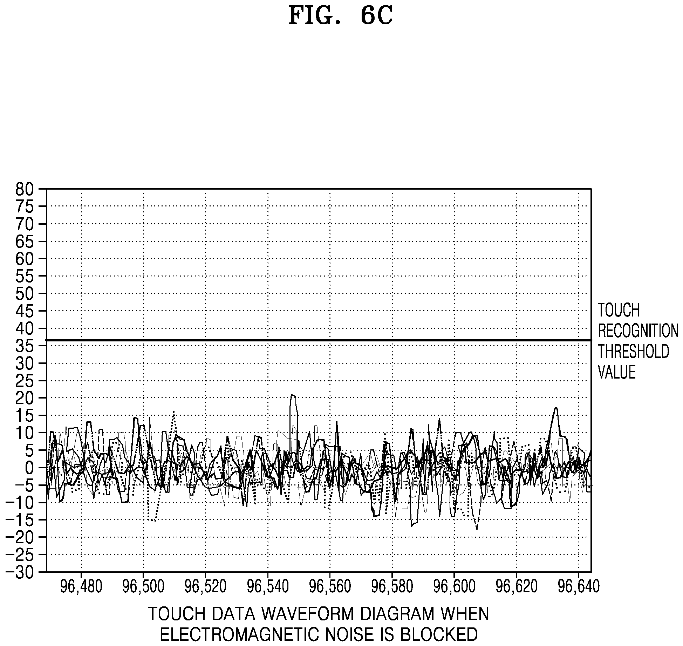

FIG. 6C is a waveform diagram illustrating touch noise during a touch operation in a heating device when a shielding conductor is provided, according to an embodiment of the present disclosure.

Referring to FIG. 6C, in the heating device 2000, the shielding conductor 2800 according to an embodiment of the present disclosure is mounted on the control PCB 2001 of the heating device 2000. Unlike FIG. 6B described above, it is verified that the amplitude of the electromagnetic noise has been noticeably reduced by the shielding conductor 2800. According to FIG. 6C, how large a value of the electromagnetic noise generated in the heating device 2000 is, the value does not reach the touch recognition threshold value, and thus, a touch recognition error does not occur.

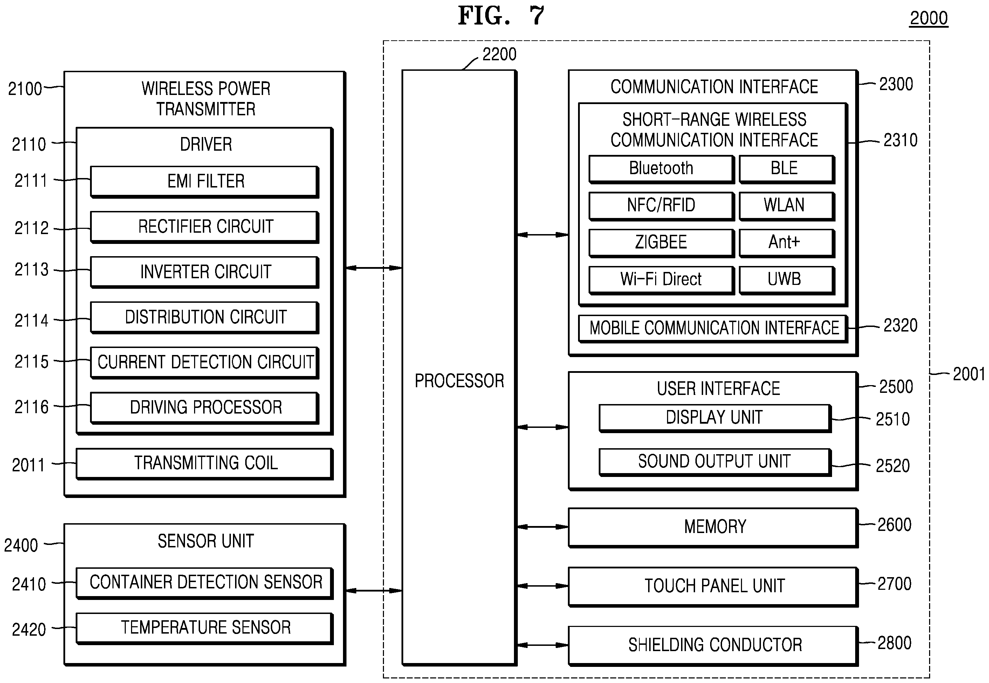

FIG. 7 is a block diagram of a heating device including an electromagnetic noise shielding conductor, according to an embodiment of the present disclosure.

As shown in FIG. 7, the heating device 2000 according to an embodiment may be an induction heating device. The heating device 2000 may include a wireless power transmitter 2100, the control PCB 2001, and a sensor unit 2400. The control PCB 2001 may include a processor 2200, a communication interface 2300, a user interface 2500, a memory 2600, the touch panel unit 2700, and the shielding conductor 2800. However, not all of the components shown are essential components. The induction heating device 2000 may be implemented by more components than those illustrated or the induction heating device 2000 may be implemented by fewer components than those illustrated. The control PCB 2001 may or may not include the sensor unit 2400. Also, the control PCB 2001 may further include a partial configuration of the wireless power transmitter 2100, for example, a driving processor 2116.

Hereinafter, the above components will be described.

The wireless power transmitter 2100 may include a driver 2110 and a transmitting coil 2011, but is not limited thereto. The driver 2110 may receive power from an external source and supply a current to the transmitting coil 2011 according to a driving control signal of the processor 2200. The driver 2110 may include an electromagnetic interference (EMI) filter 2111, a rectifier circuit 2112, an inverter circuit 2113, a distribution circuit 2114, a current detection circuit 2115, and the driving processor 2116, but is not limited thereto.

The EMI filter 2111 may block high frequency noise included in an alternating current supplied from the external source and transmit the alternating current and an alternating voltage of pre-determined frequency (e.g., 50 Hz or 60 Hz). A fuse and a relay may be provided between the EMI filter 2111 and the external source to block an overcurrent. Alternating power in which the high frequency noise is blocked by the EMI filter 2111 is supplied to the rectifier circuit 2112.

The rectifier circuit 2112 may convert the alternating power to direct power. For example, the rectifier circuit 2112 may convert the alternating voltage in which a size and polarity (a positive voltage or a negative voltage) change over time to a direct voltage in which a size and polarity are constant, and convert the alternating current in which a size and a direction (a positive current or a negative current) change over time to a direct current in which a size is constant. The rectifier circuit 2112 may include a bridge diode. For example, the rectifier circuit 2112 may include four diodes. The bridge diode may convert an alternating voltage in which polarity changes over time to a positive voltage in which polarity is constant, and convert an alternating current in which a direction changes over time to a positive current in which a direction is constant. The rectifier circuit 2112 may include a direct current (DC) link capacitor. The DC link capacitor may convert a positive voltage in which size changes over time to a direct voltage having a constant size.

The inverter circuit 2113 may include a switching circuit configured to supply or block a driving current to the transmitting coil 2011, and a resonant circuit configured to generate resonance together with the transmitting coil 2011. The switching circuit may include a first switch and a second switch. The first switch and the second switch may be connected in series to each other between a plus line and a minus line output from the rectifier circuit 2112. The first switch and the second switch may be turned on or off according to the driving control signal of the driving processor 2116.

The inverter circuit 2113 may control a current supplied to the transmitting coil 2011. For example, a size and direction of a current flowing through the transmitting coil 2011 may change according to on/off of the first switch and the second switch included in the inverter circuit 2113. In this case, an alternating current may be supplied to the transmitting coil 2011. The alternating current in sinewaves is supplied to the transmitting coil 2011 according to switching operations of the first switch and second switch. Also, a current supplied to the transmitting coil 2011 may be increased and strength of a magnetic field (an output of the induction heating device 2000) output by the transmitting coil 2011 may be increased when switching cycles of the first switch and second switch are increased (e.g., when switching frequencies of the first switch and second switch are decreased). The transmitting coil 2011 may also be referred to as an operating coil in that a heating operation is caused by forming the magnetic field.

When the heating device 2000 includes the plurality of transmitting coils 2120, the driver 2110 may include the distribution circuit 2114. The distribution circuit 2114 may include a plurality of switches configured to transmit or block a current supplied to the plurality of transmitting coils 2120, and the plurality of switches may be turned on or off according to a distribution control signal of the driving processor 2116.

The current detection circuit 2115 may include a current sensor configured to measure a current output from the inverter circuit 2113. The current sensor may transmit an electrical signal corresponding to a measured current value to the driving processor 2116.

The driving processor 2116 may determine a switching frequency (turn-on/turn-off frequency) of the switching circuit included in the inverter circuit 2113, based on output strength (power level) of the heating device 2000. The driving processor 2116 may generate the driving control signal for turning on/off the switching circuit according to the determined switching frequency.

The transmitting coil 2011 may generate the magnetic field for heating the cooking container 1000. For example, when the driving current is supplied to the transmitting coil 2011, the magnetic field may be induced around the transmitting coil 2011. When a current, i.e., the alternating current, in which a size and direction change over time, is supplied to the transmitting coil 2011, a magnetic field in which a size and direction change over time may be induced around the transmitting coil 2011. The magnetic field around the transmitting coil 2011 may pass through the top plate including tempered glass and reach the cooking container 1000 placed on the top plate. An eddy current rotating based on the magnetic field may be generated in the cooking container 1000 due to the magnetic field in which the size and direction change over time, and electric resistance heat may be generated in the cooking container 1000 due to the eddy current. The electric resistance heat is heat generated in a resistor when a current flows through the resistor, and may also be referred to as Joule heat. The cooking container 1000 is heated by the electric resistance heat and contents inside the cooking container 1000 may be heated.

The processor 2200 controls all operations of the heating device 2000. The processor 2200 may execute programs stored in the memory 2600 to control the wireless power transmitter 2100, the communication interface 2300, the sensor unit 2400, the user interface 2500, the memory 2600, and the touch panel unit 2700.

According to an embodiment of the present disclosure, the heating device 2000 may include an artificial intelligence (Al) processor. The AI processor may be manufactured in the form of an AI dedicated hardware chip or manufactured as a part of an existing general-purpose processor (e.g., a central processing unit (CPU) or an application processor) or a graphic-dedicated processor (e.g., a graphics processing unit (GPU)) to be mounted on the induction heating device 2000.

According to an embodiment of the present disclosure, the processor 2200 may control a power level to perform an automatic cooking operation, based on food temperature data obtained from a temperature sensor 2420, or control the user interface 2500 to output information for providing the user with guidance about cooking.

The communication interface 2300 may include one or more components enabling communication between the heating device 2000 and a server device. For example, the communication interface 2300 may include a short-range wireless communication interface 2310 and a mobile communication interface 2320. The short-range wireless communication interface 2310 may include a Bluetooth communication interface, a Bluetooth low energy (BLE) communication interface, a near field communication (NFC) interface, a wireless local area network (WLAN) (Wi-Fi) communication interface, a Zigbee communication interface, an infrared data association (IrDA) communication interface, a Wi-Fi direct (WFD) communication interface, an ultra-wideband (UWB) communication interface, or an Ant+ communication interface, but is not limited thereto. The mobile communication interface 2320 may transmit or receive a wireless signal to or from at least one of a base station, an external terminal, and a server, on a mobile communication network. Here, the wireless signal may include various types of data according to exchange of a voice call signal, an image call signal, or a text/multimedia message. The mobile communication interface 2320 may include a 3rd generation (3G) module, a 4th generation (4G) module, a long-tern evolution (LTE) module, a 5th generation (5G) module, a 6th generation (6G) module, a node B (NB)-Internet of things (IoT) module, or an LTE-machine type communication (LTE-M) module, but is not limited thereto.

According to an embodiment of the present disclosure, the communication interface 2300 may receive food temperature data information measured by the temperature sensor 2420.

The sensor unit 2400 may include a container detection sensor 2410 and the temperature sensor 2420, but is not limited thereto.

The container detection sensor 2410 may be a sensor configured to detect the cooking container 1000 being placed on the top plate of the heating device 2000. For example, the container detection sensor 2410 may be implemented as a current sensor, but is not limited thereto. The container detection sensor 2410 may be implemented as at least one of a proximity sensor, a touch sensor, a weight sensor, a temperature sensor, an illumination sensor, and a magnetic sensor.

The temperature sensor 2420 may detect a temperature of the cooking container 1000 placed on the top plate, a temperature of the top plate of the heating device 2000, or a temperature of the contents of the cooking container 1000. The cooking container 1000 is inductively heated by the transmitting coil 2011 and may be over-heated according to a material. Accordingly, the heating device 2000 may detect the temperature of the cooking container 1000 placed on the top plate or the top plate of the heating device 2000 and block operations of the transmitting coil 2011 when the cooking container 1000 is over-heated. The temperature sensor 2420 may be provided near the transmitting coil 2011. For example, the temperature sensor 2420 may be located at the center of the transmitting coil 2011.

According to an embodiment of the present disclosure, the temperature sensor 2420 may include a thermistor in which an electric resistance value changes according to a temperature. For example, the temperature sensor 2420 may be a negative temperature coefficient (NTC) temperature sensor, but is not limited thereto. The temperature sensor 2420 may be a positive temperature coefficient (PTC) temperature sensor.

The user interface 2500 is for outputting an audio signal or a video signal and may include the display unit 2510 and a sound output unit 2520.

When the display unit 2510 is configured as a touch screen by forming a layer structure with a touch pad, the display unit 2510 may be used as an input interface as well as an output interface. The display unit 2510 may include at least one of a liquid crystal display, a thin-film transistor-liquid crystal display, a light-emitting diode (LED), an organic light-emitting diode, a flexible display, a 3-dimensional (3D) display, and an electrophoretic display. Also, according to an embodiment of the heating device 2000, the heating device 2000 may include two or more display units 2510.

The sound output unit 2520 may output audio data received from the communication interface 2300 or stored in the memory 2600. Also, the sound output unit 2520 outputs an audio signal related to a function performed by the induction heating device 2000. The sound output unit 2520 may include a speaker, a buzzer, or the like.

According to an embodiment of the present disclosure, the display unit 2510 may output information about a current power level, information about a current cooking mode, information about a cooking region being currently used, information about a current temperature of the contents in the cooking container 1000, and information for providing guidance about cooking.

The touch panel unit 2700 is for receiving an input from the user. The touch panel unit 2700 may include at least one of touch pads (contact capacitance type, pressure resistive film type, infrared detection type, surface ultrasonic conduction type, integral tension measurement type, and Piezo effect type).

The heating device 2000 may interpret text converted by using a natural language understanding (NLU) model and obtain an utterance intention of the user. Here, an automatic speech recognition (ASR) model or the NLU model may be an AI model. The AI model may be processed by an AI dedicated processor designed in a hardware structure specialized for processing of an AI model. The AI model may be generated via training. This means that the predefined operation rules orAl model set to perform desired characteristics (or purposes) are generated by training a basic AI model with a learning algorithm that utilizes a large number of training data. The AI model may include a plurality of neural network layers. Each of the neural network layers includes a plurality of weight values, and performs a neural network arithmetic operation via an arithmetic operation between an arithmetic operation result of a previous layer and the plurality of weight values.

Linguistic understanding is a technology for recognizing human language/characters and applying/processing the same, and may include natural language processing, machine translation, dialog system, question answering, speech recognition/synthesis, and the like.

The memory 2600 may store a program for processes and controls by the processor 2200, or may store pieces of input/output data (e.g., cooking recipes, reference temperature data, and information about a remaining amount of a battery. The memory 2600 may store the AI model.

The memory 2600 may include at least one type of storage medium among a flash memory type, a hard disk type, a multimedia card micro type, a card type memory (for example, a secure digital (SD) or an extreme digital (XD) memory), random access memory (RAM), static RAM (SRAM), read-only memory (ROM), electrically erasable programmable ROM (EEPROM), programmable ROM (PROM), a magnetic memory, a magnetic disk, and an optical disk. Also, the heating device 2000 may operate a web storage or cloud server performing a storing function on the Internet.

The shielding conductor 2800 is provided between the transmitting coil 2011 and the control PCB 2001 to perform a function of shielding against an electromagnetic wave generated in the heating device 2000. A touch recognition error in the touch panel unit 2700 may be reduced or eliminated by the shielding by the shielding conductor 2800.

The shielding conductor 2800 may include the protrusion insertion portion 2801 therebelow and may be perpendicularly inserted into the control PCB 2001 through the protrusion insertion portion 2801.

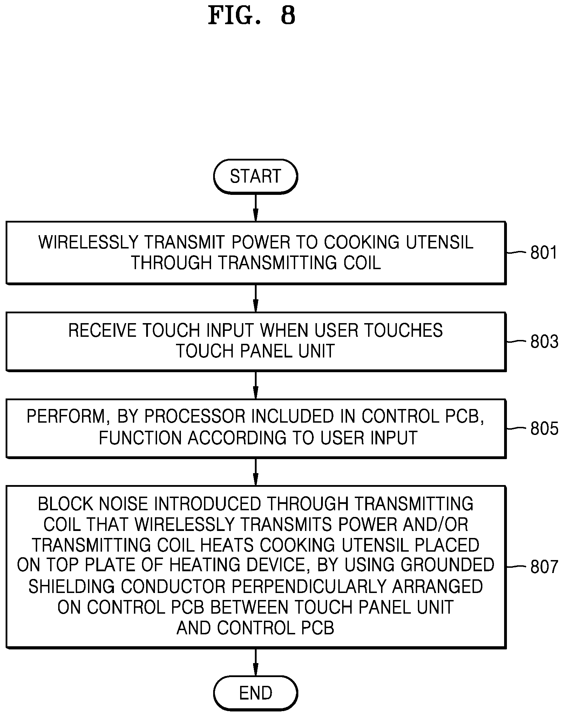

FIG. 8 is a method by which a heating device blocks electromagnetic noise, according to an embodiment of the present disclosure.

In operation 801, the heating device 2000 wirelessly transmits power to the cooking container 1000 through the transmitting coil 2011. When the cooking container 1000 includes a receiving coil, the heating device 2000 may be a device including the cooking container 1000.

In operation 803, when the user touches the touch panel unit 2700 - inputs a command - to operate the heating device 2000, the heating device 2000 receives a touch input of the user.

In operation 805, the heating device 2000 performs a function according to the user input by using the processor 2200 included in the control PCB 2001.

In operation 807, electromagnetic noise introduced while the transmitting coil 2011 that wirelessly transmits power is working and/or the transmitting coil 2011 is heating the cooking container 1000 placed on the top plate of the heating device 2000 is blocked by using the grounded shielding conductor 2800 perpendicularly arranged on the control PCB 2001 between the touch panel unit 2700 and the control PCB 2001. Here, the shielding conductor 2800 may be any one of the shielding PCB 2810 or the conductive metal bar 2820, on which a conductive pattern is etched. Also, a height of the shielding conductor 2800 may be designed to be the same as a length from a bottom of the top plate glass of the heating device 2000 to the top plate of the control PCB 2001 or to be almost the same as the length within a range of certain tolerance.

In addition, a length of the shielding conductor 2800 may be designed to be the same as an arranged length of entire touch keys of the touch panel unit 2700 or to be substantially the same as the arranged length of entire touch keys of the touch panel unit 2700 within a certain tolerance, thereby suitably blocking noise when the touch key is pressed. Alternatively, the length of the shielding conductor 2800 may be designed to be the same as a length of the control PCB 2001, thereby blocking or minimizing electromagnetic noise introduced to the control PCB 2001.

The heating device 2000 that is an induction cooking device according to an embodiment of the present disclosure is widely used in cooking to heat a container by using eddy current by receiving power, without a receiving coil. Here, a touch panel provided on a top plate of the cooking device may be affected by noise generated by wireless power transfer and an eddy current of a cooking utensil. Thus, it is required to reduce an effect of the noise to the touch panel by using a suitable shielding conductor.

The heating device 2000 according to an embodiment of the present disclosure includes at least one transmitting coil 2011 or 2120. The wireless power transmitter 2010 wirelessly transmits power to a cooking container or cooking utensil through the transmitting coil 2011 or 2120 for cooking. The heating device 2000 includes the touch panel unit 2700 configured to receive a user input. The heating device 2000 includes the PCB 2001 including the processor 2200 configured to control the wireless power transmitter 2010 according to a user input received from the touch panel unit 2700. The heating device 2000 includes the grounded shielding conductor 2800 arranged perpendicular to the control PCB 2001, between the touch panel unit 2700 and the control PCB 2001.

According to an embodiment, the shielding conductor 2800 may be any one of the shielding PCB 2810 or the conductive metal bar 2820, on which a conductive pattern is etched.

According to an embodiment, the shielding PCB 2810 may be a PCB integrated with the control PCB 2001.

According to an embodiment, the conductive pattern may be etched on both surfaces of the shielding PCB 2810.

According to an embodiment, the shielding conductor 2800 may surround the control PCB 2001 in at least three directions against the transmitting coil 2011 or 2120.

According to an embodiment, a height of the shielding conductor 2800 may be the same as a height from the control PCB 2001 to a bottom of the top plate glass of the heating device 2000 within a certain tolerance.

According to an embodiment, the shielding conductor 2800 may have a same length as a length in which touch keys of the touch panel unit 2700 are arranged within a certain tolerance.

According to an embodiment, the shielding conductor 2800 may have a same length as a length of the control PCB 2001 within a certain tolerance.

According to an embodiment, the shielding conductor 2800 includes the protrusion insertion portion 2801 and the protrusion insertion portion 2801 may be perpendicularly inserted into the control PCB 2001, assembled, and soldered.

A method by which the heating device 2000 blocks electromagnetic noise, according to an embodiment of the present disclosure, includes wirelessly transmitting power through the transmitting coil 2011 or 2120 in the wireless power transmitter 2010 that wirelessly transmits power, receiving a user input through the touch panel unit 2700, performing a function according to the user input by using the processor 2200 included in the control PCB 2001, and blocking noise introduced through the transmitting coil 2011 or 2120 that wirelessly transmits power or noise introduced during an operation of heating the cooking container 1000 placed on the top plate of the heating device 2000, by using the grounded shielding conductor 2800 perpendicularly arranged on the control PCB 2001 between the touch panel unit 2700 and the control PCB 2001.

According to an embodiment, the shielding conductor 2800 is any one of the shielding PCB 2810 or the conductive shielding metal bar 2820, on which a conductive pattern is etched.

According to an embodiment, a height of the shielding conductor 2800 may have a value within a certain tolerance from a height from the control PCB 2001 to a bottom of the top plate glass of the heating device 2000.

According to an embodiment, a length of shielding conductor 2800 may be the same as a length in which touch keys of the touch panel unit 2700 are arranged, within a certain tolerance.

According to an embodiment, the length of the shielding conductor 2800 may be the same as a length of the control PCB 2001, within a certain tolerance.

By blocking electromagnetic noise generated during a cooking process between the heating device 2000 and the cooking container 1000 by using the shielding conductor 2800 according to an embodiment of the present disclosure, occurrence of misrecognition when a user performs a touch operation on the touch panel unit of the heating device 2000 may be reduced.

A method according to an embodiment of the present disclosure may be recorded on a computer-readable recording medium by being implemented in the form of program commands executed by using various computers. The computer-readable recording medium may include at least one of a program command, a data file, and a data structure, independently or collectively. The program commands recorded in the computer-readable recording medium may be specially designed for the present disclosure or well known to one of ordinary skill in the computer software field. Examples of the computer-readable recording medium include magnetic media such as hard disks, floppy disks, and magnetic tapes, optical media such as CD-ROMs and DVDs, magneto-optical media such as floptical disks, and hardware devices specially configured to store and perform program commands, such as read-only memory (ROM), random-access memory (RAM), and flash memory. Examples of the computer command include machine codes generated by a compiler, and high-level language codes executable by a computer by using an interpreter.

Some embodiments of the present disclosure may also be realized in the form of a recording medium including instructions executable by a computer, such as a program module executed by a computer. A computer-readable medium may be an arbitrary available medium accessible by a computer, and includes all volatile and non-volatile media and separable and non-separable media. Further, examples of the computer-readable recording medium may include a computer storage medium and a communication medium. Examples of the computer storage medium include all volatile and non-volatile media and separable and non-separable media, which have been implemented by an arbitrary method or technology, for storing information such as computer-readable instructions, data structures, program modules, and other data. The communication medium typically includes a computer-readable instruction, a data structure, a program module, other data of a modulated data signal, or another transmission mechanism, and an example thereof includes an arbitrary information transmission medium. In addition, some embodiments of the present disclosure may be implemented as a computer program product or a computer program including computer-executable instructions, such as a computer-executable computer program.

A machine-readable storage medium may be provided in the form of a non-transitory storage medium. Here, the "non-transitory storage medium" only denotes a tangible device and does not contain a signal (for example, electromagnetic waves). This term does not distinguish a case where data is stored in the storage medium semi-permanently and a case where the data is stored in the storage medium temporarily. For example, the "non-transitory storage medium" may include a buffer where data is temporarily stored.

Furthermore, a method according to an embodiment of the present disclosure may be provided by being included in a computer program product. The computer program products are products that can be traded between sellers and buyers. The computer program product may be distributed in the form of machine-readable storage medium (for example, a compact disc read-only memory (CD-ROM)), or distributed (for example, downloaded or uploaded) through an application store (for example, Play Store^{™}) or directly or online between two user devices (for example, smart phones). In the case of online distribution, at least a part of the computer program product (for example, a downloadable application) may be at least temporarily generated or temporarily stored in a machine-readable storage medium, such as a server of a manufacturer, a server of an application store, or a memory of a relay server.

While the embodiments of the present disclosure have been particularly shown and described in detail, it will be understood by one of ordinary skill in the art that various changes in form and details may be made therein without departing from the spirit and scope of the present disclosure as defined by the following claims.

## Claims

1. A cooking device (2000) comprising:
a wireless power transmitter (2010) including at least one transmitting coil (2011; 2120) and configured to wirelessly transmit power through the at least one transmitting coil (2011; 2120);
a touch panel unit (2700) configured to receive a user input;
a printed circuit board (PCB) (2001) including a processor (2200) configured to control the wireless power transmitter (2010) according to a user input received from the touch panel unit (2700); and
a grounded shielding conductor (2800) arranged perpendicular to the PCB (2001) between the touch panel unit (2700) and the PCB (2001).

2. The cooking device (2000) of claim 1, wherein the grounded shielding conductor (2800) is any one of a shielding PCB (2810) or a conductive metal bar (2820), on which a conductive pattern is etched.

3. The cooking device (2000) of claim 2, wherein the shielding PCB (2810) is integrated with the PCB (2001).

4. The cooking device (2000) of claim 2 or 3, wherein a conductive pattern is etched on both sides of the shielding PCB (2810).

5. The cooking device (2000) of any one of claims 1 to 4, wherein the grounded shielding conductor (2800) surrounds the PCB (2001) in at least three directions against the at least one transmitting coil (2011; 2120).

6. The cooking device (2000) of any one of claims 1 to 5, wherein a height of the grounded shielding conductor (2800) is the same as a height from the PCB (2001) to a bottom of top plate glass of the cooking device (2000) within a certain tolerance.

7. The cooking device (2000) of any one of claims 1 to 6, wherein the grounded shielding conductor (2800) has a same length as a length in which a touch key of the touch panel unit (2700) is arranged within a certain tolerance.

8. The cooking device (2000) of any one of claims 1 to 7, wherein the grounded shielding conductor (2800) has a same length as a length of the PCB (2001) within a certain tolerance.

9. The cooking device (2000) of any one of claims 1 to 8, wherein the grounded shielding conductor (2800) includes a protrusion insertion portion (2801) and the protrusion insertion portion (2801) is perpendicularly inserted into the PCB (2001).
